# EUROPEAN PATENT SPECIFICATION

(11) **EP 2 790 211 B1**
(45) Date of publication and mention of the grant of the patent: **20.06.2018**
(21) Application number: 13163167.3
(22) Date of filing: 10.04.2013
(51) Int. Cl.: H01L 21/768, H01L 23/48

(54) **Method of producing a through-substrate via in a semiconductor device and semiconductor device comprising a through-substrate via**
Verfahren zum Herstellen eines Durchkontaktierungssubstratwegs in einer Halbleitervorrichtung und Halbleitervorrichtung mit dem Durchkontaktierungssubstratweg
Procédé de production d'un via traversant un substrat dans un dispositif semi-conducteur et dispositif semi-conducteur comprenant un tel via

(43) Date of publication of application: 15.10.2014
(73) Proprietor: AMS AG, 8141 Premstätten (AT)
(72) Inventor: Kraft, Jochen, 8600 Bruck an der Mur (AT); Löffler, Bernhard, 8200 Gleisdorf (AT); Koppitsch, Günther, 8501 Lieboch (AT); Rohracher, Karl, 8041 Graz (AT)
(74) Representative: Epping - Hermann - Fischer

(56) References cited:
- US-A1- 2012 256 319

## Description

DE 10 2009 004 725 A1 discloses stacked semiconductor devices with a bond layer including a buried contact pad, which is connected with a surface metal layer by means of a metallization arranged in a through-wafer via. The contact pad and the surface metal layer can be connected with a metal plane of a wiring or with a contact pad provided for a connection with a further semiconductor device.

US 2011/0260284 A1 discloses a method for the manufacture of a semiconductor component having a connection pad arranged in the insulation layer of an SOI substrate. A contact hole above the connection pad is provided with a metallization on side walls and on the connection pad. The metallization is contacted with a top metal on the top side of the component.

US 2012/0286430 A1 discloses a method of producing a semiconductor device with through-wafer interconnect. A semiconductor substrate is provided with a contact pad. An opening is formed through the semiconductor material from an upper surface to the contact pad. A dielectric layer is applied in the opening, and a metallization is produced to contact the pad. The metallization is separated from the substrate by the dielectric layer. A top-metal is arranged to contact the metallization at the edge of the opening and is covered by a protection layer and a passivation.

US 2012/0256319 A1 discloses a method of manufacturing a semiconductor device having interconnections in the substrate. A pad opening filled with metal is arranged above a pad interconnection provided with a barrier metal layer and an etching stopper layer, which may be formed by a Ti or TiN film or by plural barrier metal layers such as Ti or TiN layers stacked. The barrier metal layer is not penetrated by the pad opening and the metal forming the interconnection. Further interconnections are formed in an interconnection layer.

It is an object of the present invention to disclose a method of producing a through-substrate via that is compatible with the integration of CMOS components and a semiconductor device comprising such a through-substrate via.

This object is achieved with the method of producing a semiconductor device according to claim 1 and with the semiconductor device according to claim 11. Variants and embodiments derive from the dependent claims.

The method of producing a through-substrate via in a semiconductor device comprises the steps of arranging an intermetal dielectric on or above a main surface of a semiconductor body, arranging at least one metal layer in the intermetal dielectric, and arranging a stop layer of electrically conductive material between a section of the metal layer and the semiconductor body, so that the stop layer is electrically connected to the section of the metal layer. A via opening is formed from a rear surface that is opposite the main surface at least up to the stop layer, the via opening extending towards the section of the metal layer but not into the metal layer, which is not exposed.

In a variant of the method the stop layer is formed from TiN or TaN.

In a further variant of the method, a dielectric layer provided for the intermetal dielectric is arranged on or above the main surface of the semiconductor body, the stop layer is arranged on or above the dielectric layer, and the section of the metal layer is arranged on or above the stop layer, before the via opening is formed.

An electrically conductive liner, which is thinner than the stop layer, is arranged between the metal layer and the semiconductor body.

In a further variant of the method, the liner is electrically connected to the metal layer.

In a further variant of the method, a section of the liner is arranged contiguous with the stop layer.

In a further variant of the method, the stop layer is thicker than the liner by at least 50%. This means that the stop layer and the liner are together at least two and a half times as thick as the liner alone.

In a further variant of the method, the liner is formed from the same material as the stop layer.

A dielectric layer provided for the intermetal dielectric is arranged on or above the main surface of the semiconductor body, a contact opening is formed in the dielectric layer, the liner is applied on the dielectric layer and in the contact opening, and an electrically conductive contact plug is produced in the contact opening.

In a further variant of the method, the contact plug is provided for an electric connection to an integrated circuit in the semiconductor body.

In a further variant of the method, the stop layer is arranged on a section of the liner, and the section of the metal layer is arranged on the stop layer.

In a further variant of the method, a section of the liner is applied on the stop layer, and the metal layer is applied on the liner.

The semiconductor device comprises a semiconductor body having a main surface and at least one structured metal layer arranged above the main surface. A via opening extends from a rear surface that is opposite the main surface towards a section of the metal layer. A metallization is arranged in the via opening, forms a through-substrate via and is electrically connected to the section of the metal layer. An electrically conductive liner is arranged between the metal layer and the semiconductor body, the liner being electrically connected to the metal layer. A stop layer of electrically conductive material is arranged between the section of the metal layer and the metallization, so that the metallization contacts the stop layer.

In an embodiment of the semiconductor device the stop layer is formed from TiN or TaN.

In a further embodiment a section of the liner is contiguous with the stop layer.

In a further embodiment the liner is thinner than 160 nm.

In a further embodiment the liner is formed from the same material as the stop layer.

The semiconductor device further comprises an integrated circuit in the semiconductor body, and at least one further section of the metal layer, which is provided for an electric connection of the integrated circuit. A further section of the liner is arranged at the further section of the metal layer, and a further layer of the material of the stop layer is arranged at the further section of the metal layer.

The semiconductor device further comprises an electrically conductive contact plug connecting the integrated circuit with the further section of the metal layer, the contact plug being arranged between the further section of the liner and the further layer of the material of the stop layer.

The following is a detailed description of examples of the method in conjunction with the appended figures.
- Figure 1: is a schematic cross section of an illustrative embodiment of a semiconductor device which is not part of the claimed invention.
- Figure 2: is a cross section according to Figure 1 for an intermediate product of an example of the method.
- Figure 3: is a cross section according to Figure 2 after the application of further layers.
- Figure 4: is a cross section according to Figure 3 after the formation of the stop layer.
- Figure 5: is a cross section according to Figure 4 after the formation of an intermetal dielectric including a further metal layer.
- Figure 6: is a cross section according to Figure 5 after the formation of a via opening.

- Figure 7: is a cross section according to Figure 6 after the application of a via metallization.
- Figure 8: is a schematic cross section of the embodiment of the semiconductor device.
- Figure 9: is a cross section according to Figure 8 for an intermediate product of a further example of the method.
- Figure 10: is a cross section according to Figure 9 after the application of a liner and a metal layer.
- Figure 11: is a cross section according to Figure 10 after a partial removal of the metal layer.
- Figure 12: is a cross section according to Figure 11 after the application of a further metal layer.
- Figure 13: is a cross section according to Figure 12 after the structuring of the further metal layer.
- Figure 14: is a cross section according to Figure 13 after the formation of a via opening.

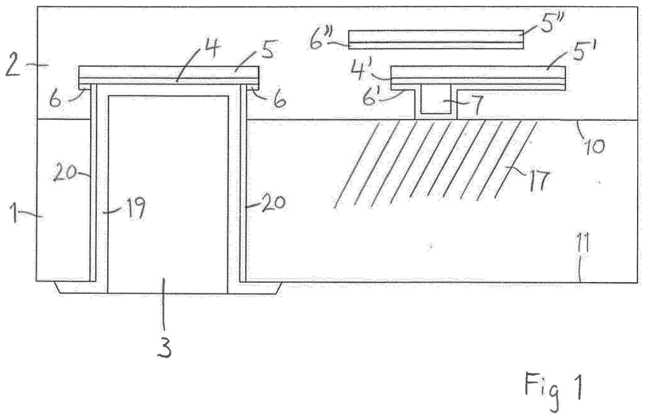

Figure 1 is a schematic cross section of a semiconductor device that is not part of the claimed method. A semiconductor body 1, which may be a silicon substrate or wafer, for instance, is provided with an intermetal dielectric 2 on or above a main surface 10. The intermetal dielectric 2 may be an oxide of the semiconductor material, especially silicon oxide, for instance. At least one structured metal layer 5, 5' is embedded in the intermetal dielectric 2. There are preferably two or more levels of metal layers 5, 5', 5'', which can be structured and can especially be used to form a wiring of an integrated circuit 17, which may comprise CMOS components, for instance. The structure of the integrated components is not essential to the invention, and the integrated circuit 17 is therefore only schematically indicated by the hatching in Figure 1. The sections 5, 5' of the lower metal layer shown in Figure 1 can be applied and structured in the same metallization layer, for example. The upper section 5'' belongs to a further metallization layer, which is arranged on a higher level and separated from the first metallization layer by the intermetal dielectric 2. A section 5' of the metal layer 5, 5' can be connected to the integrated circuit 17 by a contact plug 7 or by a plurality of contact plugs 7, which are formed from an electrically conductive material like tungsten, for instance.

The metal layers 5, 5', 5" may be provided with a thin liner 6, 6', 6" of electrically conductive material, which is arranged in electric connection with the relevant metal layer 5, 5', 5" on the side facing the semiconductor body 1. The liner 6, 6', 6" may be TiN or TaN, for instance, or other materials that are conventionally used as liners in CMOS processes. Figure 1 shows a structured metal layer 5, 5' provided with a liner 6, 6' and a further structured metal layer 5" provided with a further liner 6". There may be more than two levels of metal layers, and each metal layer may be provided with a liner.

A via opening 3 is formed from the rear side 11 of the semiconductor body 1. The via opening 3 is preferably produced by etching the semiconductor material of the semiconductor body 1 and then etching further into the intermetal dielectric 2. The via opening 3 is produced opposite a section 5 of the metal layer 5, 5' that is to be connected by a through-substrate via. The through-substrate via can be produced in further prosess steps by an application of a metallization 19, which may be insulated from the semiconductor body 1 by a further dielectric layer 20 arranged in the via opening 3.

A stop layer 4 is arranged between the semiconductor body 1 and a section 5 of the metal layer 5, 5' that is arranged in the region provided for the via opening 3. The stop layer 4 is provided to stop the etching of the via opening 3 before the section 5 of the metal layer 5, 5' is exposed. Even if the liner 6, 6' is provided, and the material of the liner 6, 6' is selected to be suitable as an etch stop, the liner 6, 6' may be too thin and not suitable to stop the etching process sufficiently abruptly to prevent the metal layer 5, 5' from being exposed. The stop layer 4 guarantees that the etching step can be performed in such a way that the section 5 of the metal layer 5, 5' is still covered at the bottom of the via opening 3 after the etching has finished. This allows the subsequent use of cleaning agents that attack a standard metal used in CMOS processes, like aluminum, even if the metal layer 5, 5' is formed from such a standard metal. As the metal layer 5, 5' stays covered, the cleaning agent will not adversely affect the metal surface, which is thus kept in the best condition for further process steps that are performed to produce the through-substrate via.

The described method has the further advantage that the liner 6, 6' may be as thin as it is usually applied in the part of the wiring that is provided for an integrated circuit 17, especially a CMOS circuit. In particular, the liner 6, 6' may be thinner than typically 160 nm, for instance, or even thinner than 100 nm. The liner 6, 6' can comprise a section 6 at the section 5 of the metal layer 5, 5' opposite the via opening 3 and further sections 6' that can be arranged at further sections 5' of the metal layer 5, 5' intended for conventional plugs interconnecting different levels of the wiring and terminals of the integrated circuit. It is not necessary that material of the stop layer 4 is also present outside the region of the through-substrate via. Figure 1 shows a further layer 4' of the material of the stop layer 4, the further layer 4' being in contact with a further section 5' of the lower metal layer 5, 5'. The further layer 4' may be applied after the application of the liner 6, 6' and after the formation of the contact plug 7 and may be formed as a portion of a layer provided for the stop layer 4. The application of the stop layer 4 does not impose any restrictions on the formation of the liner 6, 6'.

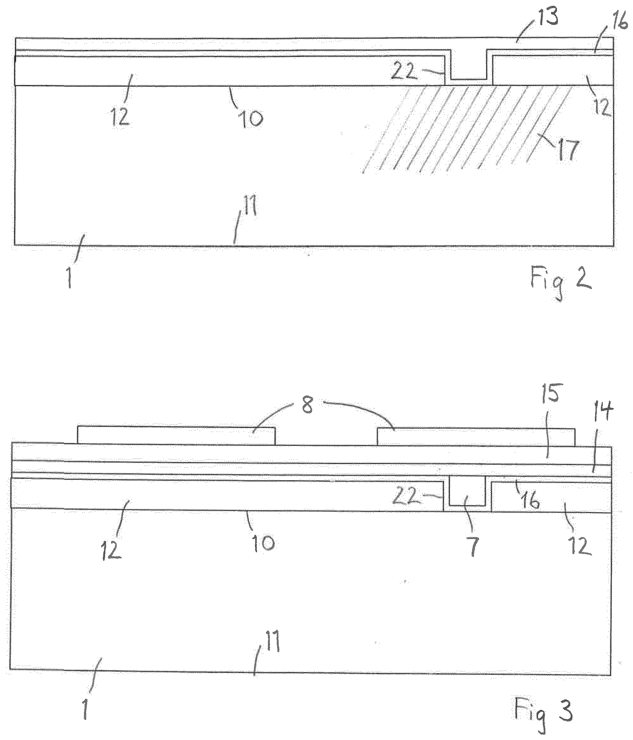

Figure 2 is a cross section according to Figure 1 for an intermediate product of an example not being part of the claimed method after the application of a liner and a metal layer. A dielectric layer 12, which is provided for the intermetal dielectric 2, is applied on or above the main surface 10 of the semiconductor body 1. The dielectric layer 12 may be an oxide of the semiconductor material, especially silicon oxide, for instance. At least one opening 22 for a contact plug is formed in the dielectric layer 12. A thin layer 16 of an electrically conductive material provided for the liner 6, 6' is then applied. The material of the liner 6, 6' may be TiN or TaN, which are conventionally used in CMOS processes. The layer 16 of the material of the liner 6, 6' is preferably applied on the surface of the dielectric layer 12 and in each contact opening 22 as well. Then a layer of an electrically conductive material, preferably a metal layer 13, which may be tungsten, is applied on the layer 16 of the material of the liner 6, 6', so that the opening 22 is filled.

Figure 3 is a cross section according to Figure 2 after the metal layer 13 has been partially removed to leave the contact plug 7. A layer 14 of the material that is provided for the stop layer 4 and a further metal layer 15 are applied, which may cover the entire surface of the dielectric layer 12. The layers 14, 15, 16 are then structured by use of a mask 8 into the sections 4, 4', 5, 5', 6, 6' shown in Figure 1.

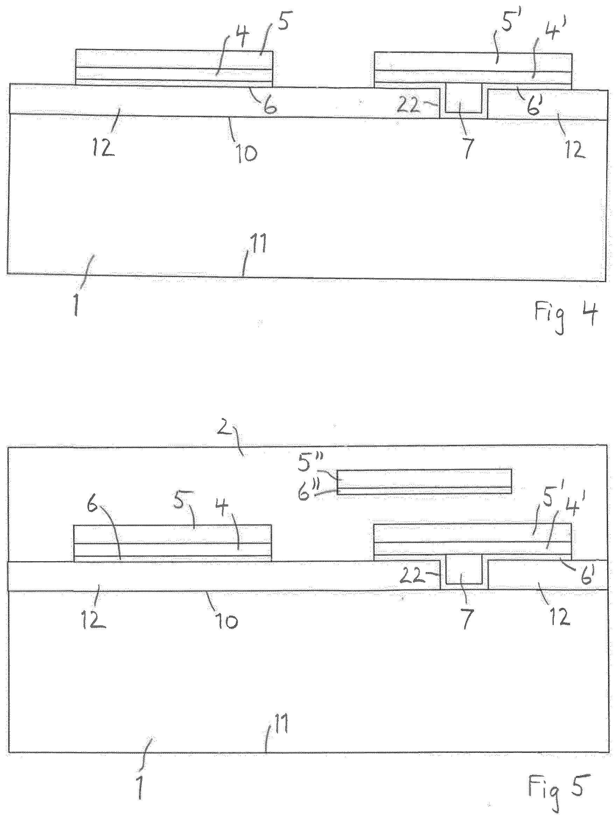

Figure 4 is a cross section of the result of the structuring, which especially yields the stop layer 4 and the section 5 of the metal layer 5, 5' that is located in the region where the via opening is to be formed. The mask 8 is preferably removed after the structuring.

Figure 5 is a cross section according to Figure 4 after the formation of the intermetal dielectric 2 including a section 5" of a further metal layer in contact with a section 6" of a further liner.

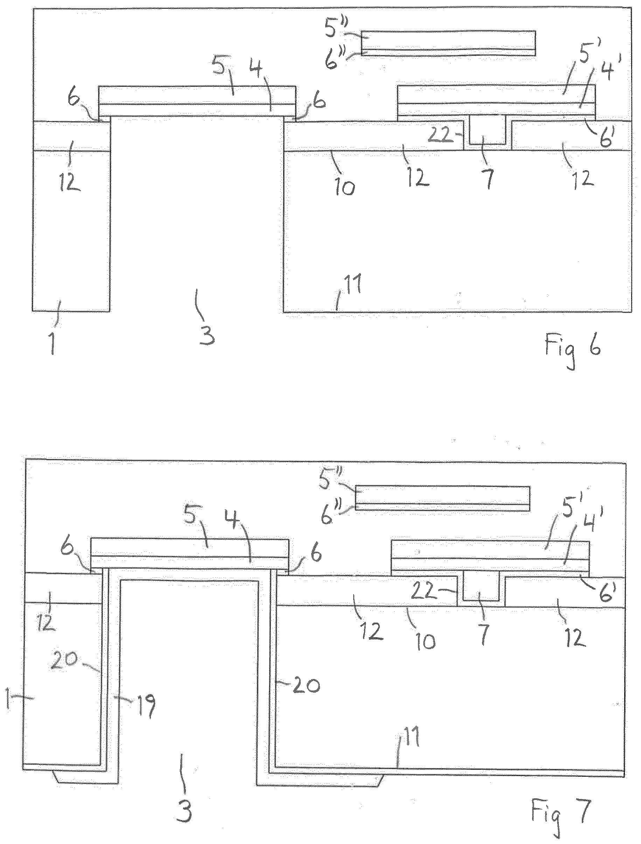

Figure 6 is a cross section according to Figure 5 after the formation of a via opening 3. Figure 6 shows how the via opening 3 can be produced from the rear surface 11 in the semiconductor body 1 and in the intermetal dielectric 2 without uncovering the section 5 of the metal layer 5, 5'. A thin layer of electrically conductive material remains between the section 5 of the metal layer 5, 5' and the via opening 3. Depending on the etch process, the thin remaining layer may be formed by a remaining portion of the stop layer 4, as shown in Figure 6, or by the stop layer 4 and a remaining portion of the section 6 of the liner 6, 6'. If no liner 6, 6' has been applied, only the residual layer portion of the stop layer 4 remains to cover the section 5 of the metal layer 5, 5'. The via opening 3 is provided for a through-substrate via, which is subsequently produced by the application of a metallization according to the prior art cited above. The metallization is used to connect the metal layer 5, 5' with a further electric conductor arranged at the rear surface 11.

Figure 7 is a cross section according to Figure 6 after the application of a dielectric layer 20 at the sidewall of the via opening 3 and a via metallization 19. The elements of the cross section according to Figure 7 correspond to the elements of the cross section according to Figure 1 and are designated with the same reference numerals. The dielectric layer 12 shown in Figures 2 to 7 forms a lowest layer portion of the intermetal dielectric 2.

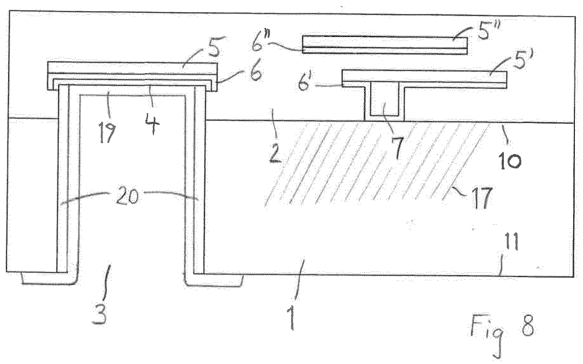

Figure 8 is a schematic cross section of a semiconductor device according to the claimed method. A semiconductor body 1, which may be a silicon substrate or wafer, for instance, is provided with an intermetal dielectric 2 on or above a main surface 10. The intermetal dielectric 2 may be an oxide of the semiconductor material, especially silicon oxide, for instance. At least one structured metal layer 5, 5' is embedded in the intermetal dielectric 2. There are preferably two or more levels of metal layers 5, 5', 5", which can be structured and can especially be used to form a wiring of an integrated circuit 17, which is only schematically indicated by the hatching in Figure 8. The sections 5, 5' of the lower metal layer shown in Figure 8 can be applied and structured in the same metallization layer, for example. The upper section 5" belongs to a further metallization layer, which is arranged on a higher level and separated from the first metallization layer by the intermetal dielectric 2. A section 5' of the metal layer 5, 5' can be connected to the integrated circuit 17 by a contact plug 7 or by a plurality of contact plugs 7, which are formed from an electrically conductive material like tungsten, for instance.

A thin liner 6, 6', 6" of electrically conductive material may be arranged contiguous with each metal layer 5, 5', 5" on the side facing the semiconductor body 1. The liner 6, 6', 6'' is thus arranged between the adjacent section of the metal layer 5, 5', 5" and the semiconductor body 1. The liner 6, 6', 6'' may be TiN or TaN, for instance. Figure 8 shows a structured metal layer 5, 5' provided with a liner 6, 6' and a further structured metal layer 5'' provided with a further liner 6''. There may be more than two levels of metal layers, and each metal layer may be provided with a liner.

A via opening 3 is formed from the rear side 11 of the semiconductor body 1. The via opening 3 is preferably produced by etching the semiconductor material of the semiconductor body 1 and then etching further into the intermetal dielectric 2. The via opening 3 is produced opposite a section 5 of the metal layer 5, 5' that is to be connected by a through-substrate via. The through-substrate via can be produced in further prosess steps by an application of a metallization 19, which may be insulated from the semiconductor body 1 by a further dielectric layer 20 arranged in the via opening 3.

A stop layer 4 is arranged between the semiconductor body 1 and a section 5 of the metal layer 5, 5' that is arranged in the region provided for the via opening 3. The stop layer 4 is provided to stop the etching of the via opening 3 before the section 5 of the metal layer 5, 5' is exposed.

The liner 6, 6' may be as thin as usual in the part of the wiring that is provided for the integrated circuit 17. In particular, the liner 6, 6' may be thinner than typically 160 nm, for instance, or even thinner than 100 nm. The liner 6, 6' can comprise a section 6 at the section 5 of the metal layer 5, 5' opposite the via opening 3 and further sections 6' that can be arranged at further sections 5' of the metal layer 5, 5' intended for conventional plugs interconnecting different levels of the wiring and terminals of the integrated circuit. The stop layer 4 is preferably not present outside the region of the through-substrate via. The application of the stop layer 4 does therefore not impose any restrictions on the formation of the liner 6, 6'.

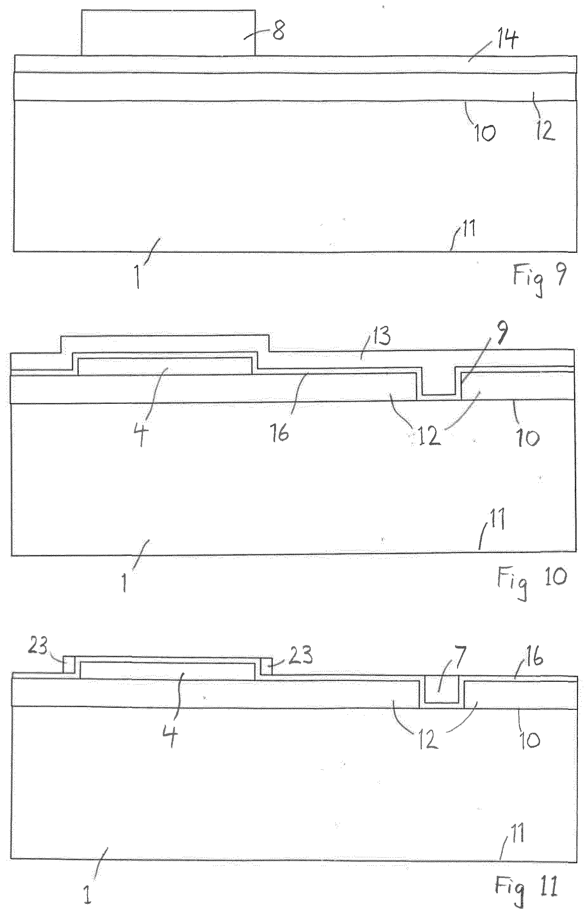

Figure 9 is a cross section according to Figure 8 for an intermediate product of the further example of the method. A dielectric layer 12, which is provided for the intermetal dielectric 2, is applied on or above the main surface 10 of the semiconductor body 1. The dielectric layer 12 may be an oxide of the semiconductor material, especially silicon oxide, for instance. A layer 14 of the material that is provided for the stop layer 4 is applied on the dielectric layer 12 and may cover the entire surface of the dielectric layer 12. A mask 8 can be used to structure the entire layer 14 into a remaining portion forming the stop layer in the region where the via opening is to be formed. After the structuring of the stop layer 4, as shown in Figure 10, the mask 8 is preferably removed.

Figure 10 is a cross section according to Figure 9 after the application of a liner and a metal layer. When the stop layer 4 has been structured, a contact opening 9 can be produced in the dielectric layer 12 in each location where a contact plug is to be arranged. The contact opening 9 or a plurality of contact openings 9 can be etched in the dielectric layer 12 using a further mask, which is subsequently removed and hence not shown in Figure 10. A thin layer 16 of an electrically conductive material provided for the liner 6, 6' can then be applied. The layer 16 of the material of the liner 6, 6' is preferably applied in each contact opening 9 as well. Then a layer of an electrically conductive material, preferably a metal layer 13, which may be tungsten, for instance, is applied to fill the contact opening 9. The metal layer 13 is partially removed to leave the contact plug 7 as shown in Figure 11.

Figure 11 is a cross section according to Figure 10 after the partial removal of the metal layer 13, which is preferably removed till the level of the layer 16 of the material of the liner 6, 6' is reached. The remaining material of the metal layer 13 forms the contact plug 7 in the contact opening 9. Residual portions 23 of the metal layer 13 may be left at the edges or flanks of the stop layer 4. The metal layer 13 may instead be completely removed in the regions outside the contact openings 9.

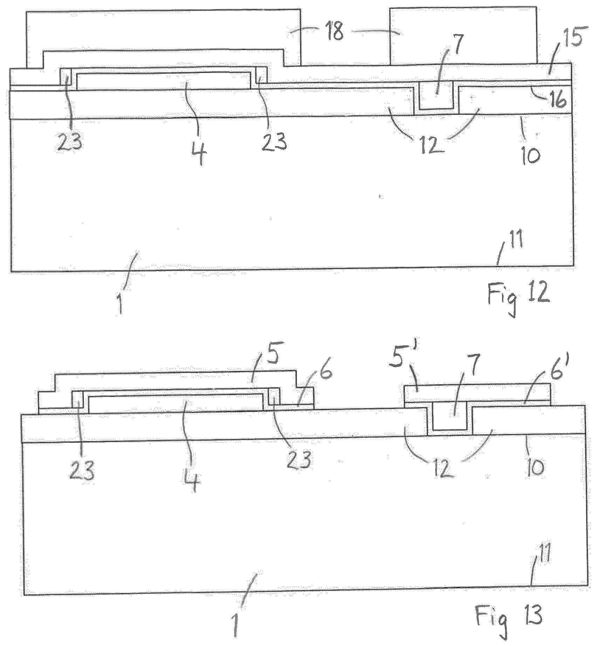

Figure 12 is a cross section according to Figure 11 after the application of a further metal layer 15, which is then structured by use of a further mask 18 into the sections 5, 5' shown in Figure 8. The structuring also yields the section 5 of the metal layer 5, 5' that is located in the region where the via opening is to be formed.

Figure 13 is a cross section according to Figure 12 after the structuring of the further metal layer 15. The structured metal layer 5, 5' comprises a section 5 in the region of the via opening to be formed and a further section 5' in the region of the contact plug 7, which is thus electrically connected to the wiring including the metal layer 5, 5'.

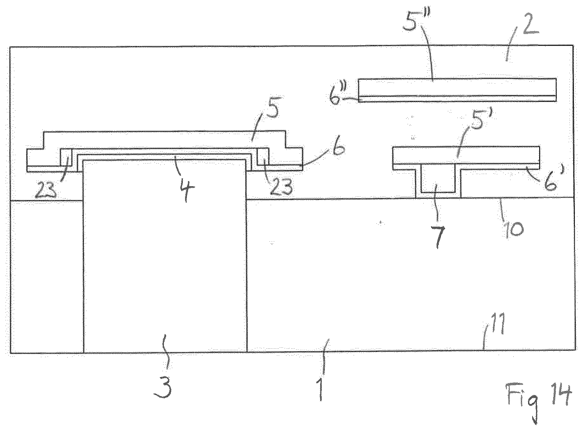

Figure 14 is a cross section according to Figure 13 after the formation of a via opening 3. Except for details that are due to the described example of the method, the elements of the cross section according to Figure 14 correspond to the elements of the cross section according to Figure 8 and are designated with the same reference numerals. The dielectric layer 12 shown in Figures 9 to 13 forms a lowest layer portion of the intermetal dielectric 2. Further metal layers 5'', which may each be provided with a liner 6'', and further layers of the intermetal dielectric 2 can be applied to form a wiring of the semiconductor device.

Figure 14 shows how the via opening 3 can be produced from the rear surface 11 in the semiconductor body 1 and in the intermetal dielectric 2 without uncovering the section 5 of the metal layer 5, 5'. A thin layer of electrically conductive material remains between the section 5 of the metal layer 5, 5' and the via opening 3. Depending on the etch process, the thin remaining layer may be formed by the section 6 of the liner 6, 6' alone or by the section 6 of the liner 6, 6' and a remaining layer portion of the stop layer 4, as shown in Figure 14. If no liner 6, 6' has been applied, only the residual layer portion of the stop layer 4 remains to cover the section 5 of the metal layer 5, 5'. The via opening 3 is provided for a through-substrate via, which is subsequently produced by the application of a metallization according to the prior art cited above. The metallization is used to connect the metal layer 5, 5' with a further electric conductor arranged at the rear surface 11.

The method has the advantage that the surface of the metal layer 5, 5' stays smooth and no hillocks are formed. After the formation of the via opening 3, the metal layer 5, 5' is still completely covered and hence protected against corrosion under the attack of wet cleaning agents and/or during subsequent process steps that are performed at elevated temperatures. Furthermore, no voids are formed in the metal, nor are polymers or other residuals introduced in the course of the cleaning steps.

### List of reference numerals

- 1: semiconductor body
- 2: intermetal dielectric
- 3: via opening
- 4: stop layer
- 4': further layer of the material of the stop layer
- 5: section of a metal layer
- 5': further section of the metal layer
- 5": section of a further metal layer
- 6: section of a liner
- 6': further section of the liner
- 6'': section of a further liner
- 7: contact plug
- 8: mask
- 9: contact opening
- 10: main surface
- 11: rear surface
- 12: dielectric layer
- 13: metal layer
- 14: entire layer of the material of the stop layer
- 15: further metal layer
- 16: layer of the material of the liner
- 17: integrated circuit
- 18: further mask
- 19: metallization
- 20: dielectric layer
- 22: opening in the dielectric layer
- 23: residual portion of the metal layer

## Claims

1. A method of producing a through-substrate via in a semiconductor device, comprising:
- arranging a dielectric layer (12) provided for an intermetal dielectric (2) on or above a main surface (10) of a semiconductor body (1),
- arranging a stop layer (4) of electrically conductive material on or above the dielectric layer (12) and forming a contact opening (9) in the dielectric layer (12), the contact opening (9) being spaced apart from the stop layer (4),
- applying an electrically conductive liner (6, 6') on the dielectric layer (12) and in the contact opening (9), the electrically conductive liner (6, 6') being thinner than the stop layer (4),
- producing an electrically conductive contact plug (7) in the contact opening (9),
- arranging at least one structured metal layer (5, 5') in the intermetal dielectric (2), the stop layer (4) being arranged between a section (5) of the metal layer (5, 5') and the semiconductor body (1), so that the stop layer (4) is electrically connected to the section (5) of the metal layer (5, 5'), and
- forming a via opening (3) from a rear surface (11) that is opposite the main surface (10) at least up to the stop layer (4) without exposing the metal layer (5, 5'), the via opening (3) extending towards the section (5) of the metal layer (5, 5').

2. The method of claim 1, wherein the stop layer (4) is formed from TiN or TaN.

3. The method of claim 1 or 2, wherein
the section (5) of the metal layer (5, 5') is arranged on or above the stop layer (4), before the via opening (3) is formed.

4. The method of one of claims 1 to 3, wherein
the electrically conductive liner (6, 6') is arranged between the metal layer (5, 5') and the semiconductor body (1), so that the liner (6, 6') is electrically connected to the metal layer (5, 5').

5. The method of claim 4, wherein a section (6) of the liner (6, 6') is arranged contiguous with the stop layer (4).

6. The method of claim 5, wherein the stop layer (4) is thicker than the liner (6, 6') by at least 50%.

7. The method of one of claims 4 to 6, wherein the liner (6, 6') is formed from the same material as the stop layer (4) .

8. The method of one of claims 4 to 7, wherein the contact plug (7) is provided for an electric connection to an integrated circuit (17) in the semiconductor body (1).

9. The method of one of claims 4 to 8, wherein the stop layer (4) is arranged on a section (6) of the liner (6, 6'), and the section (5) of the metal layer (5, 5') is arranged on the stop layer (4).

10. The method of one of claims 4 to 8, wherein a section (6) of the liner (6, 6') is applied on the stop layer (4), and the metal layer (5, 5') is applied on the liner (6, 6').

11. A semiconductor device, comprising:
- a semiconductor body (1) having a main surface (10) and at least one structured metal layer (5, 5') arranged above the main surface (10),
- an integrated circuit (17) in the semiconductor body (1),
- a via opening (3) from a rear surface (11) that is opposite the main surface (10), the via opening (3) extending towards a section (5) of the metal layer (5, 5'),
- a metallization (19) arranged in the via opening (3), the metallization (19) forming a through-substrate via and being electrically connected to the section (5) of the metal layer (5, 5'),
- at least one further section (5') of the metal layer (5, 5'), the further section (5') being provided for an electric connection of the integrated circuit (17),
- an electrically conductive liner (6, 6') arranged between the metal layer (5, 5') and the semiconductor body (1), the liner (6, 6') being electrically connected to the metal layer (5, 5'), a further section (6') of the liner (6, 6') being arranged at the further section (5') of the metal layer (5, 5'),
- a stop layer (4) of electrically conductive material being arranged between the section (5) of the metal layer (5, 5') and the metallization (19), so that the metallization (19) contacts the stop layer (4),
- a further layer (4') of the material of the stop layer (4) being arranged at the further section (5') of the metal layer (5, 5'), and
- an electrically conductive contact plug (7) connecting the integrated circuit (17) with the further section (5') of the metal layer (5, 5'), the contact plug (7) being arranged between the further section (6') of the liner (6, 6') and the further layer (4') of the material of the stop layer (4).

12. The semiconductor device of claim 11, wherein the stop layer (4) is formed from TiN or TaN.

13. The semiconductor device of claim 11 or 12, wherein a section (6) of the liner (6, 6') is contiguous with the stop layer (4).

14. The semiconductor device of one of claims 11 to 13,
wherein the liner (6, 6') is thinner than 160 nm.

15. The semiconductor device of one of claims 11 to 14,
wherein the liner (6, 6') is formed from the same material as the stop layer (4).

## Patentansprüche

1. Verfahren zum Herstellen einer Substratdurchkontaktierung in einem Halbleiterbauteil, Folgendes umfassend:
- Anordnen einer für ein Intermetalldielektrikum (2) vorgesehenen dielektrischen Schicht (12) auf oder über einer Hauptfläche (10) eines Halbleiterkörpers (1),
- Anordnen einer Stoppschicht (4) aus elektrisch leitfähigem Material auf oder über der dielektrischen Schicht (12), und Ausbilden einer Kontaktöffnung (9) in der dielektrischen Schicht (12), wobei die Kontaktöffnung (9) von der Stoppschicht (4) beabstandet ist,
- Aufbringen einer elektrisch leitfähigen Auflage (6, 6') auf der dielektrischen Schicht (12) und in der Kontaktöffnung (9), wobei die elektrisch leitfähige Auflage (6, 6') dünner ist als die Stoppschicht (4),
- Herstellen eines elektrisch leitfähigen Kontaktsteckers (7) in der Kontaktöffnung (9),
- Anordnen mindestens einer strukturierten Metallschicht (5, 5') im Intermetalldielektrikum (2), wobei die Stoppschicht (4) zwischen einem Abschnitt (5) der Metallschicht (5, 5') und dem Halbleiterkörper (1) so angeordnet ist, dass die Stoppschicht (4) elektrisch an den Abschnitt (5) der Metallschicht (5, 5') angeschlossen ist, und
- Ausbilden einer Durchkontaktierungsöffnung (3) ausgehend von einer Rückseite (11), die der Hauptfläche (10) entgegengesetzt ist, zumindest bis zur Stoppschicht (4), ohne die Metallschicht (5, 5') freizulegen, wobei sich die Durchkontaktierungsöffnung (3) zum Abschnitt (5) der Metallschicht (5, 5') hin erstreckt.

2. Verfahren nach Anspruch 1, wobei die Stoppschicht (4) aus TiN oder TaN gebildet ist.

3. Verfahren nach Anspruch 1 oder 2, wobei
der Abschnitt (5) der Metallschicht (5, 5'), bevor die Durchkontaktierungsöffnung (3) ausgebildet wird, auf oder über der Stoppschicht (4) angeordnet wird.

4. Verfahren nach einem der Ansprüche 1 bis 3, wobei die elektrisch leitfähige Auflage (6, 6') so zwischen der Metallschicht (5, 5') und dem Halbleiterkörper (1) angeordnet wird, dass die Auflage (6, 6') elektrisch an die Metallschicht (5, 5') angeschlossen ist.

5. Verfahren nach Anspruch 4, wobei ein Abschnitt (6) der Auflage (6, 6') angrenzend an die Stoppschicht (4) angeordnet wird.

6. Verfahren nach Anspruch 5, wobei die Stoppschicht (4) um mindestens 50 % dicker ist als die Auflage (6, 6').

7. Verfahren nach einem der Ansprüche 4 bis 6, wobei die Auflage (6, 6') aus demselben Material gebildet ist wie die Stoppschicht (4).

8. Verfahren nach einem der Ansprüche 4 bis 7, wobei der Kontaktstecker (7) für einen elektrischen Anschluss an eine integrierte Schaltung (17) im Halbleiterkörper (1) vorgesehen ist.

9. Verfahren nach einem der Ansprüche 4 bis 8, wobei die Stoppschicht (4) auf einem Abschnitt (6) der Auflage (6, 6') angeordnet wird, und der Abschnitt (5) der Metallschicht (5, 5') auf der Stoppschicht (4) angeordnet wird.

10. Verfahren nach einem der Ansprüche 4 bis 8, wobei ein Abschnitt (6) der Auflage (6, 6') auf die Stoppschicht (4) aufgebracht wird, und die Metallschicht (5, 5') auf die Auflage (6, 6') aufgebracht wird.

11. Halbleiterbauteil, Folgendes aufweisend:
- einen Halbleiterkörper (1) mit einer Hauptfläche (10) und mindestens einer strukturierten Metallschicht (5, 5'), die über der Hauptfläche (10) angeordnet ist,
- eine integrierte Schaltung (17) im Halbleiterkörper (1),
- eine Durchkontaktierungsöffnung (3) ausgehend von einer Rückseite (11), die der Hauptfläche (10) entgegengesetzt ist, wobei sich die Durchkontaktierungsöffnung (3) zu einem Abschnitt (5) der Metallschicht (5, 5') hin erstreckt,
- eine Metallisierung (19), die in der Durchkontaktierungsöffnung (3) angeordnet ist, wobei die Metallisierung (19) eine Substratdurchkontaktierung bildet und elektrisch an den Abschnitt (5) der Metallschicht (5, 5') angeschlossen ist,
- mindestens einen weiteren Abschnitt (5') der Metallschicht (5, 5'), wobei der weitere Abschnitt (5') für einen elektrischen Anschluss der integrierten Schaltung (17) vorgesehen ist,
- eine elektrisch leitfähige Auflage (6, 6'), die zwischen der Metallschicht (5, 5') und dem Halbleiterkörper (1) angeordnet ist, wobei die Auflage (6, 6') elektrisch an die Metallschicht (5, 5') angeschlossen ist, wobei ein weiterer Abschnitt (6`) der Auflage (6, 6') am weiteren Abschnitt (5') der Metallschicht (5, 5') angeordnet ist,
- eine Stoppschicht (4) aus elektrisch leitfähigem Material, die so zwischen dem Abschnitt (5) der Metallschicht (5, 5') und der Metallisierung (19) angeordnet ist, dass die Metallisierung (19) die Stoppschicht (4) kontaktiert,
- wobei eine weitere Schicht (4') des Materials der Stoppschicht (4) am weiteren Abschnitt (5') der Metallschicht (5, 5') angeordnet ist, und
- einen elektrisch leitfähigen Kontaktstecker (7), der die integrierte Schaltung (17) mit dem weiteren Abschnitt (5') der Metallschicht (5, 5') verbindet, wobei der Kontaktstecker (7) zwischen dem weiteren Abschnitt (6') der Auflage (6, 6') und der weiteren Schicht (4') des Materials der Stoppschicht (4) angeordnet ist.

12. Halbleiterbauteil nach Anspruch 11, wobei die Stoppschicht (4) aus TiN oder TaN gebildet ist.

13. Halbleiterbauteil nach Anspruch 11 oder 12, wobei ein Abschnitt (6) der Auflage (6, 6') an die Stoppschicht (4) angrenzt.

14. Halbleiterbauteil nach einem der Ansprüche 11 bis 13, wobei die Auflage (6, 6') dünner als 160 nm ist.

15. Halbleiterbauteil nach einem der Ansprüche 11 bis 14,
wobei die Auflage (6, 6') aus demselben Material gebildet ist wie die Stoppschicht (4).

## Revendications

1. Procédé de production d'une interconnexion traversante de substrat dans un dispositif semiconducteur, comprenant :
- l'agencement d'une couche de diélectrique (12) prévue pour un diélectrique intermétallique (2) sur ou au-dessus d'une surface principale (10) d'un corps semiconducteur (1),
- l'agencement d'une couche d'arrêt (4) de matériau électriquement conducteur sur ou au-dessus de la couche de diélectrique (12) et la formation d'une ouverture de contact (9) dans la couche de diélectrique (12), l'ouverture de contact (9) étant espacée de la couche d'arrêt (4),
- l'application d'un garnissage (6, 6') électriquement conducteur sur la couche de diélectrique (12) et dans l'ouverture de contact (9), le garnissage (6, 6') électriquement conducteur étant plus mince que la couche d'arrêt (4),
- la production d'une fiche de contact (7) électriquement conductrice dans l'ouverture de contact (9),
- l'agencement d'au moins une couche de métal structurée (5, 5') dans le diélectrique intermétallique (2), la couche d'arrêt (4) étant agencée entre une section (5) de la couche de métal (5, 5') et le corps semiconducteur (1), de telle sorte que la couche d'arrêt (4) soit électriquement connectée à la section (5) de la couche de métal (5, 5'),
et
- la formation d'une ouverture d'interconnexion (3) depuis une surface arrière (11) qui est opposée à la surface principale (10) au moins jusqu'à la couche d'arrêt (4) sans exposer la couche de métal (5, 5'), l'ouverture d'interconnexion (3) s'étendant vers la section (5) de la couche de métal (5, 5').

2. Le procédé de la revendication 1, sachant que la couche d'arrêt (4) est composée de TiN ou de TaN.

3. Le procédé de la revendication 1 ou 2, sachant que la section (5) de la couche de métal (5, 5') est agencée sur ou au-dessus de la couche d'arrêt (4), avant que l'ouverture d'interconnexion (3) soit formée.

4. Le procédé de l'une des revendications 1 à 3, sachant que le garnissage (6, 6') électriquement conducteur est agencé entre la couche de métal (5, 5') et le corps semiconducteur (1), de telle sorte que le garnissage (6, 6') soit électriquement connecté à la couche de métal (5, 5').

5. Le procédé de la revendication 4, sachant qu'une section (6) du garnissage (6, 6') est agencée de façon contiguë à la couche d'arrêt (4).

6. Le procédé de la revendication 5, sachant que la couche d'arrêt (4) est d'au moins 50 % plus épaisse que le garnissage (6, 6').

7. Le procédé de l'une des revendications 4 à 6, sachant que le garnissage (6, 6') est formé du même matériau que la couche d'arrêt (4).

8. Le procédé de l'une des revendications 4 à 7, sachant que la fiche de contact (7) est prévue pour une connexion électrique à un circuit intégré (17) dans le corps semiconducteur (1).

9. Le procédé de l'une des revendications 4 à 8, sachant que la couche d'arrêt (4) est agencée sur une section (6) du garnissage (6, 6'), et la section (5) de la couche de métal (5, 5') est agencée sur la couche d'arrêt (4).

10. Le procédé de l'une des revendications 4 à 8, sachant qu'une section (6) du garnissage (6, 6') est appliquée sur la couche d'arrêt (4), et la couche de métal (5, 5') est appliquée sur le garnissage (6, 6').

11. Dispositif semiconducteur, comprenant :
- un corps semiconducteur (1) présentant une surface principale (10) et au moins une couche de métal structurée (5, 5') agencée au-dessus de la surface principale (10),
- un circuit intégré (17) dans le corps semiconducteur (1),
- une ouverture d'interconnexion (3) depuis une surface arrière (11) qui est opposée à la surface principale (10), l'ouverture d'interconnexion (3) s'étendant vers une section (5) de la couche de métal (5, 5'),
- une métallisation (19) agencée dans l'ouverture d'interconnexion (3), la métallisation (19) formant une interconnexion traversante de substrat et étant électriquement connectée à la section (5) de la couche de métal (5, 5'),
- au moins une section (5') supplémentaire de la couche de métal (5, 5'), la section (5') supplémentaire étant prévue pour une connexion électrique du circuit intégré (17),
- un garnissage (6, 6') électriquement conducteur agencé entre la couche de métal (5, 5') et le corps semiconducteur (1), le garnissage (6, 6') étant électriquement connecté à la couche de métal (5, 5'), une section (6') supplémentaire du garnissage (6, 6') étant agencée au niveau de la section (5') supplémentaire de la couche de métal (5, 5'),
- une couche d'arrêt (4) du matériau électriquement conducteur étant agencée entre la section (5) de la couche de métal (5, 5') et la métallisation (19), de telle sorte que la métallisation (19) soit en contact avec la couche d'arrêt (4),
- une couche (4') supplémentaire du matériau de la couche d'arrêt (4) étant agencée au niveau de la section (5') supplémentaire de la couche de métal (5, 5'), et
- une fiche de contact (7) électriquement conductrice connectant le circuit intégré (17) à la section (5') supplémentaire de la couche de métal (5, 5'), la fiche de contact (7) étant agencée entre la section (6') supplémentaire du garnissage (6, 6') et la couche (4') supplémentaire du matériau de la couche d'arrêt (4).

12. Le dispositif semiconducteur de la revendication 11, sachant que la couche d'arrêt (4) est composée de TiN ou de TaN.

13. Le dispositif semiconducteur de la revendication 11 ou 12, sachant qu'une section (6) du garnissage (6, 6') est contiguë à la couche d'arrêt (4).

14. Le dispositif semiconducteur de l'une des revendications 11 à 13, sachant que le garnissage (6, 6') est plus mince que 160 nm.

15. Le dispositif semiconducteur de l'une des revendications 11 à 14, sachant que le garnissage (6, 6') est composé du même matériau que la couche d'arrêt (4).
